Europäisches Patentamt

European Patent Office

Office européen des brevets

(11) Numéro de publication : **0 491 599 A1**

# (12) DEMANDE DE BREVET EUROPEEN

(21) Numéro de dépôt : **91403328.7**

(22) Date de dépôt : **09.12.91**

(51) Int. Cl.$^5$ : **B23K 3/06, H05K 3/34**

(30) Priorité : **17.12.90 FR 9015781**

(43) Date de publication de la demande :
**24.06.92 Bulletin 92/26**

(84) Etats contractants désignés :
**CH DE GB IT LI SE**

(71) Demandeur : **SOLEMS S.A. Société dite:**
**3, rue Léon Blum Z.I. Les Glaises**
**F-91120 Palaiseau (FR)**

(72) Inventeur : **Schmitt, Jacques**
**51, rue Grande Rue**
**F-91620 La Ville du Bois (FR)**

(74) Mandataire : **Lerner, François et al**
**5, rue Jules Lefèbvre**
**F-75009 Paris (FR)**

(54) **Procédé et appareil pour apporter un composé métallique fondu à un substrat.**

(57)   L'invention a pour objet l'apport local à un substrat (7) d'un composé métallique (3) en des emplacements ou le long de pistes (10) de ce substrat, en vue d'assurer leur soudage.

Selon l'invention, on place le composé métallique dans un réservoir, on élève par des moyens de chauffage (25) la température de ce composé pour obtenir un composé fondu, on place le réservoir contenant le composé métallique fondu au-dessus du substrat, on coule à l'endroit desdits emplacements ou pistes ce composé sur le substrat de manière à créer à la surface du substrat une couche locale d'apport dudit composé, et on laisse refroidir cette couche pour qu'elle se soude au substrat.

L'invention s'applique notamment à l'étamage de composants électroniques.

FIG.1

L'invention concerne tout d'abord un procédé pour apporter localement un composé métallique en fusion à un substrat, en des emplacements où le long de pistes de ce substrat avec lequel ledit composé est compatible chimiquement, en vue d'assurer leur soudage.

En particulier dans le domaine de l'électronique, une grande variété d'objets manufacturés comportent sur leur surface des pistes métalliques formant des bandes de connexion mécanique ou électrique.

Ces pistes sont en général composées d'alliages métalliques de soudure ou de brasure dont les constituants les plus fréquents sont l'étain, le plomb, l'argent, le bismuth, l'indium, ....

Ces alliages se présentent souvent sous la forme d'eutectiques et sont couramment proposés dans le commerce en lingots, grenaille, fils ou crème à braser.

Les pistes métalliques ainsi réalisées ont en général une épaisseur d'environ 10 à plusieurs centaines de micromètres et peuvent remplir plusieurs fonctions, telles en particulier que le transport de courant électrique, le renforcement mécanique et la tenue à la corrosion d'une couche mince sous-jacente également métallique, ou encore l'épaississement local assurant une connexion électrique et/ou mécanique entre le substrat et un raccordement extérieur.

D'une façon générale, pour former une couche de soudure à la surface d'un substrat, il convient que la surface de ce substrat soit mouillable par l'alliage fondu, c'est-à-dire que ce dernier puisse, à l'endroit de l'apport, être compatible chimiquement en vue d'une coopération mécanique entre lui-même et le composé métallique d'apport, afin par exemple qu'un soudage puisse s'opérer entre eux. Pour cela, il faut que le substrat soit localement revêtu d'un film métallique compatible avec l'alliage ou que ce substrat soit constitué en un métal soudable exempt de salissures ou de traces d'oxydation. Si la surface du substrat n'est pas un métal soudable, il faut alors que l'alliage soit spécialement sélectionné pour être capable de mouiller spécifiquement ce type de substrat (par exemple les alliages à base d'indium qui mouillent certaines céramiques et certains verres).

En bref, pour apporter un composé métallique en fusion sur un substrat, on peut aujourd'hui procéder de la manière suivante :

a) on maintient dans un réservoir le composé métallique dans son état fondu par chauffage via des moyens de chauffage intégrés à ce réservoir,

b) on place le réservoir au-dessus du substrat,

c) on coule localement le composé fondu sur ce substrat pour y créer en surface une couche d'apport,

d) et on laisse refroidir cette couche pour qu'elle se soude au substrat.

Il s'avère toutefois difficile de doser avec précision les quantités déposées en assurant une coulée précise et convenablement répartie, qu'il s'agisse d'une coulée par point(s) ou pour former un cordon de plus ou moins grande largeur ou épaisseur. Il importe également de bien doser les quantités déposées pour réduire les chocs thermiques avec le substrat.

L'invention a notamment pour objet de remédier à ces inconvénients.

A cet effet, le procédé de l'invention qui reprend les étapes ci-dessus énoncées, se caractérise notamment en ce que lors de l'étape c) on coule par gravité le composé métallique fondu directement sur le substrat et on dose la quantité de composé à couler en imposant, lors de la coulée, l'action combinée d'un courant électrique que l'on fait circuler à travers le composé s'écoulant et d'un champ magnétique statique.

Ainsi, quelle que soit la taille de l'objet à métalliser, on va éviter de lui imposer un choc thermique global et l'on va pouvoir ne réaliser la métallisation que sur une surface relativement réduite, limitée par exemple à quelques pistes ou quelques reprises de contact en des emplacements déterminés.

De préférence, dans le cadre de l'invention, on coulera sur la surface du substrat le composé métallique fondu à une température supérieure à sa température de fusion. Ainsi, il sera possible, sans recourir à une source extérieure de chaleur supplémentaire, d'obtenir à l'endroit de l'interface substrat/alliage une température qui atteigne ou dépasse la température de fusion de l'alliage, assurant ainsi les meilleures conditions pour l'obtention d'une soudure de qualité.

Selon une autre caractéristique de l'invention, en fin de l'étape c) précitée, on interrompt la coulée en inversant le sens de circulation dudit courant électrique imposé. Ainsi on pourra interrompre précisément la coulée juste au moment voulu, quasiment "à la goutte près".

Outre le procédé qui vient d'être présenté, l'invention se rapporte également à un appareil destiné à assurer cet apport de composé métallique en surface d'un substrat en vue de leur soudage relatif.

Dans ce domaine, il existe aujourd'hui des appareils du type comprenant :

– un réservoir pour contenir ledit composé dans son état fondu,

– des moyens de chauffage pouvant entourer ce réservoir pour que la température du composé métallique y atteigne au moins sa température de fusion,

– un conduit auquel se raccorde ledit réservoir en partie inférieure et à travers lequel le composé peut couler vers le substrat pour être versée sur lui,

– et des moyens de dosage pour doser la quantité de composé métallique s'écoulant dans le conduit.

Or, ces appareils présentent bien entendu les inconvénients liés aux procédés d'apport auxquels ils sont destinés, à savoir en particulier parfois des imprécisions de dosage des coulées, surtout lorsque celles-ci doivent être effectuées sur des zones restreintes, le long de cordons ou pistes, voire en des emplacements ponctuels.

Pour remédier notamment à ces inconvénients, l'appareil de l'invention se caractérise en particulier en ce que les moyens précités de dosage ou de régulation de la coulée comprennent une pompe magnétohydrodynamique disposée localement autour dudit conduit et reliée à une source d'alimentation en courant continu pour que ledit composé soit coulé sur le substrat de façon régulée, a priori sous forme d'un cordon ou d'un point de soudure.

Ainsi, on va pouvoir disposer d'un appareil performant tout à fait adapté en particulier à la mise en oeuvre du procédé objet de l'invention.

Selon une autre caractéristique de l'invention, l'appareil pourra également comprendre en outre :

– un tube d'injection de gaz plongeant dans le composé métallique fondu jusque vers le fond du réservoir,

– et des moyens d'alimentation en gaz dudit tube, ce(s) gaz étant de préférence constitué(s) par un gaz neutre ou réducteur pour maintenir alors, en surface du composé, une atmosphère non oxydante ou du moins confinée.

D'autres caractéristiques et avantages de l'invention apparaîtront encore de la description qui va suivre, laquelle est donnée à titre d'exemple non limitatif, en relation avec des figures d'accompagnement dans lesquelles

– la figure 1 est une vue schématique en coupe d'une partie essentielle de l'appareil de l'invention comprenant le réservoir à métal ainsi que le moyen de dosage de la quantité de métal à délivrer,

– la figure 2 est une vue de dessus de la partie repérée II sur la figure 1 montrant la pompe magnétohydrodynamique utilisée en tant que moyen de dosage,

– la figure 3 est une vue schématique en perspective conforme à celle de la figure 1 et montrant en particulier ladite pompe magnétohydrodynamique,

– les figures 4 et 5 sont des vues de détail illustrant deux perfectionnements prévus sur l'appareil de l'invention pour parfaire le dépôt du métal sur le substrat,

– et la figure 6 est une vue générale schématique en perspective d'un mode possible de réalisation de l'appareil de l'invention, dans son ensemble.

Dans ce qui suit sera décrit un exemple de réalisation destiné à l'apport d'étain fondu.

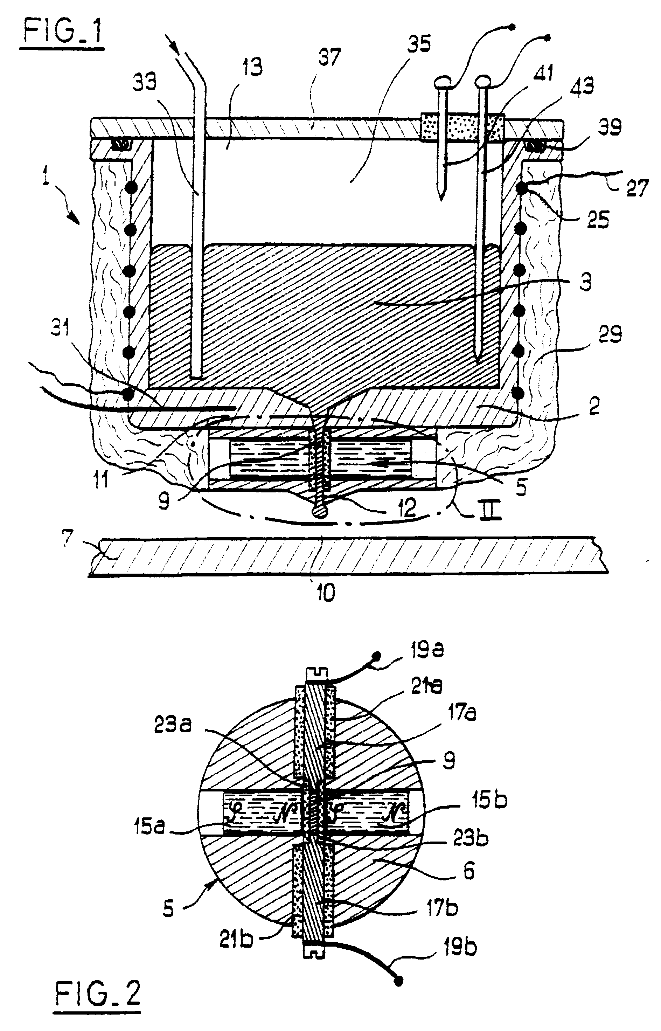

Sur la figure 1 tout d'abord, un réservoir 1 contenant du métal en fusion 3 domine une pompe magnétohydrodynamique 5 formant moyen de dosage du métal 3 qui peut s'écouler par gravité vers le substrat 7 à métalliser, à travers un conduit 9 formé à travers le fond 11 du réservoir et, comme on le verra ci-après, à travers le corps de la pompe 5, pour former un cordon de dépôt plus ou moins large et épais, voire un point local de soudure.

Le conduit 9 qui est sensiblement vertical est disposé de façon à déboucher en partie inférieure au-dessus de pistes ou emplacements 10 du substrat dont les zones ou chemins ont été préalablement délimité(e)s par exemple au moyen d'un film formant masque 14.

Dans la méthode proposée, l'alliage métallique est fourni sous la forme de métal fondu permettant donc un apport de métal compact, c'est-à-dire non poreux. La matière première servant à recharger le réservoir à travers la large ouverture 13 qu'il présente à sa partie supérieure peut être constituée de métal brut, sous forme ou lingot ou de grenaille.

La surface à métalliser du substrat 7 est soit froide, soit portée à une température contrôlée restant inférieure à la température de fusion de l'alliage (un tel chauffage étant classique, les moyens d'échauffement correspondants du substrat non pas été représentés).

Pour obtenir une bonne soudure ou brasure, il est indispensable qu'au moins pendant un bref moment la température de l'interface substrat 7/alliage d'apport 3 atteigne ou dépasse la température de fusion de cet alliage.

Aussi, afin d'éviter d'avoir à adjoindre au réservoir des moyens de chauffage annexes, est-il conseillé d'assurer un apport d'alliage à une température supérieure à sa température de fusion (par exemple de l'ordre de 30 à 50°C). Cet excès de température dépendra en pratique des chaleurs spécifiques et des conductivités thermiques de l'alliage fondu et du substrat. On préférera donc que la température de l'alliage fondu à la sortie du conduit 9 soit réglable.

Dans l'invention, le métal fondu est donc apporté vers le substrat 7 suivant un cheminement descendant. Le métal s'écoule du réservoir 1 vers le substrat par gravité.

Pour doser la quantité de métal fondu à déposer, l'utilisation d'une pompe magnétohydrodynamique a été préférée, afin d'assurer une régulation optimale du débit. Son principe fait appel aux forces de LAPLACE résultant de l'action croisée d'un courant passant à travers le métal fondu et d'un champ magnétique statique.

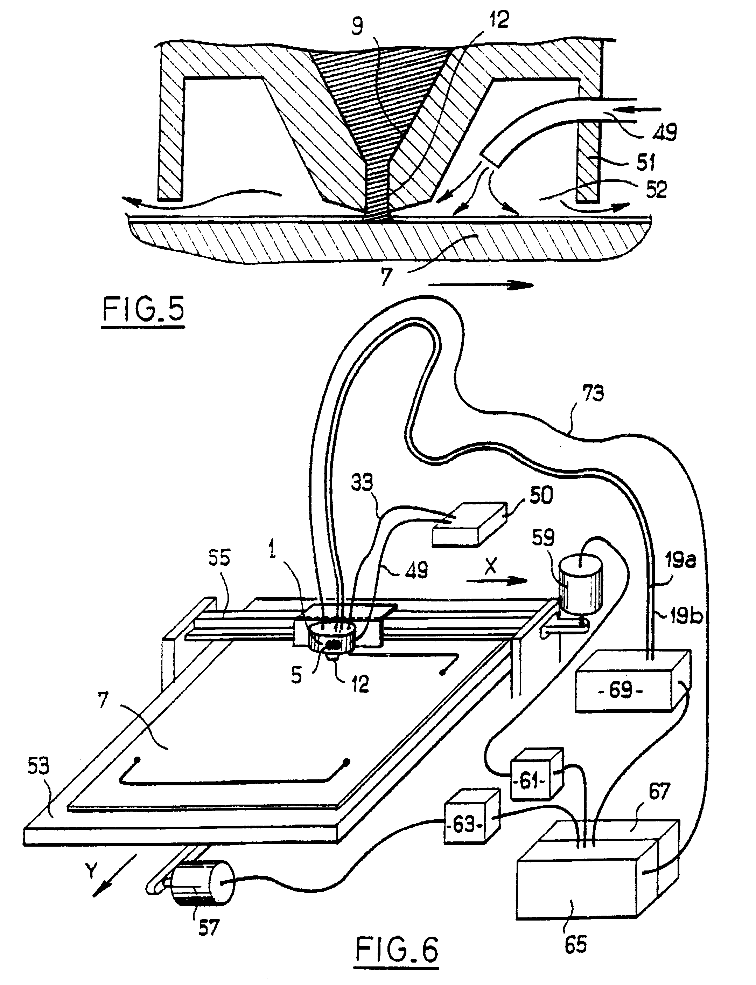

Cette pompe 5 qui entoure le conduit 9 en partie inférieure du réservoir, comporte en l'espèce deux aimants permanents en céramique ou en alliage magnétique 15a, 15b et deux électrodes 17a, 17b. Les deux aimants 15a, 15b permanents sont disposés l'un en face de l'autre, sensiblement au même niveau autour du conduit 9, leurs pôles opposés se faisant face, tandis que les deux électrodes 17a et 17b sont disposées en face l'une de l'autre, sensiblement au même niveau que les aimants en étant orientées sensiblement perpendiculairement à ces derniers, également autour du conduit. Les deux électrodes sont chacune reliées à une source commune 69 de courant continu (voir figure 6) via les conducteurs 19a et 19b. Pour leur isolation électrique par rapport au corps 6 de la pompe, chaque électrode est enrobée par un manchon isolant 21a, 21b.

Plus particulièrement sur la figure 2, on remarquera qu'à l'endroit de la pompe, le conduit 9, qui présente en l'espèce alors une forme sensiblement rectangulaire en section, est limité sur deux de ses côtés opposés par les extrémités frontales dénudées des électrodes et, sur ses deux côtés latéraux complémentaires par deux couches d'isolant électrique 23a, 23b ou de diélectrique s'étendant le long des deux pôles opposés se faisant face des aimants. Ces couches d'isolement pourront être réalisées en verre, en céramique ou encore dans un alliage métallique peu conducteur, ces réalisations étant adaptées pour que le courant entre les électrodes 19a, 19b passe pour l'essentiel par le chemin le moins résistif, à savoir le métal fondu circulant dans le conduit traversant la pompe.

De préférence, le corps 6 de cette pompe pourra être séparé du corps 2 du réservoir qui sera avantageusement réalisé en une matière non mouillable par le métal en fusion et dont la température de fusion sera de toute façon supérieure à celle du métal qui y est contenu.

Pour que ce métal puisse être délivré sur le substrat sous-jacent à une température supérieure à sa température de fusion, une résistance chauffante 25 réliée par les conducteurs 27 à une source de puissance (telle que la source 69) et intégré ou noyée dans la paroi du réservoir, pourra permettre de chauffer ce réservoir à la température requise, une couche 29 d'isolant thermique entourant le corps du réservoir et la pompe 5. Un capteur de température 31 débouchant dans le corps 2 du réservoir permet d'effectuer des relevés de température et, via une unité de régulation (non représentée), de réguler la température d'ensemble de ce réservoir.

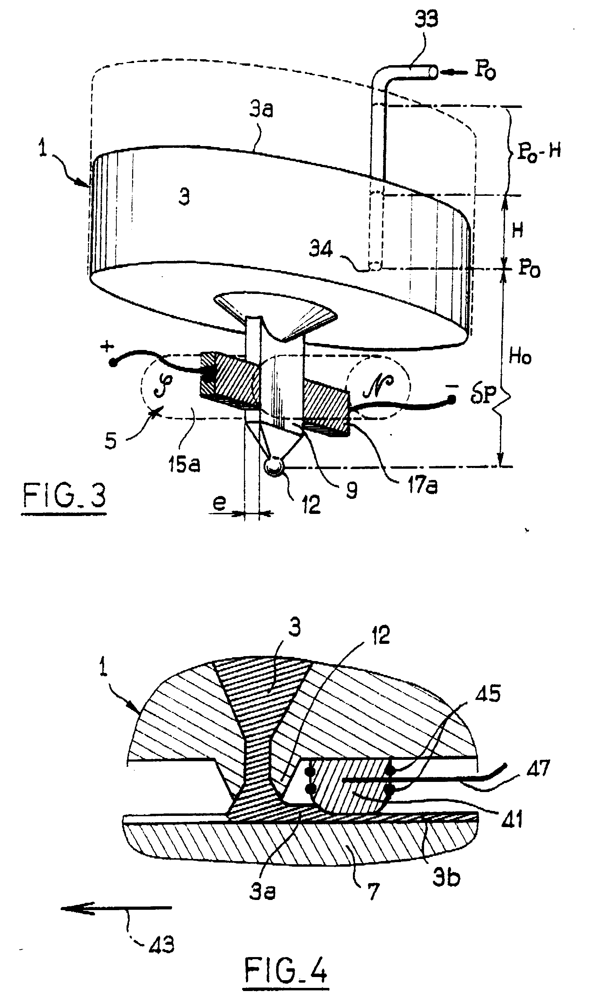

Pour éviter l'oxydation du métal fondu contenu dans le réservoir, un tube 33 plongeant jusque vers le fond du réservoir peut assurer la diffusion d'un gaz spécial (gaz neutre ou réducteur) à l'intérieur du métal en fusion, permettant de maintenir en 35, au-dessus de la surface libre du métal fondu, une atmosphère non oxydante. Pour ce faire, le tube 33 est relié à une source 50 (voir figure 4) d'alimentation en gaz, tel que de l'azote sec ou de l'Argon.

Pour maintenir cette atmopshère confinée, un couvercle 37 ferme l'ouverture supérieure 13 du réservoir, ceci si nécessaire de façon étanche, via le joint périphérique 39.

Pour contrôler le niveau du bain à l'intérieur du réservoir, le couvercle 37 est également traversé de préférence de façon étanche par deux sondes de niveau, telles que les électrodes 41, 43 qui descendent dans le réservoir jusqu'à deux niveaux d'élévation différents correspondants l'un à la position la plus haute (électrode 41), l'autre à la position la plus basse (électrode 43). En pratique, ces électrodes pourront être réliées à une unité de contrôle permettant par exemple d'avertir l'utilisateur en cas de hausse ou de baisse excessive du niveau dans le réservoir.

L'appareil décrit qui combine donc un réservoir thermostaté contenant l'alliage fondu et, à sa base, un canal ou conduit de distribution passant à travers une pompe magnétohydrodynamique pour conduire à une buse de distribution, consiste donc en un appareil distributeur de métal fondu qui peut être notamment servo-commandé par l'intermédiaire du courant circulant dans la pompe. Cet appareil peut en particulier métalliser des pistes sur le substrat si un mouvement tangentiel relatif de l'appareil par rapport au substrat est assuré le long du dessin des pistes pendant l'écoulement du métal fondu. Il conviendra toutefois que pendant ces mouvements, le réservoir demeure sensiblement vertical.

Intéressons-nous maintenant à la figure 3 pour présenter brièvement les distributions de pression au niveau du conduit d'écoulement du métal, ainsi que l'effet de la pompe magnétohydrodynamique.

Sur cette figure 3, on remarquera tout d'abord que le conduit 9 présente ici tout d'abord une forme avec une section de parallélépipède rectangle puis, en partie inférieure, sous la pompe 5, un étranglement final 12 de section par exemple sensiblement circulaire, permettant d'obtenir en sortie un fin cordon de métal.

Sur cette figure 3, on a repéré par :
– $P_O$ : la surpression de gaz (par rapport à la pression atmosphérique) pouvant être injectée vers le fond du réservoir par l'intermédiaire du tube 33,
– H : la pression hydrostatique liée à la hauteur de métal fondu entre l'ouverture de fond 34 du tube 33 et la surface libre 3a du métal fondu et par
– $H_0$ : la pression hydrostatique liée à la hauteur de métal fondu entre le niveau de référence à la pression $P_O$ et l'orifice de la buse de sortie 12.

Au niveau de cette buse, la pression dans le métal fondu est donc finalement :
$$P_b = P_0 + H_0 + \delta P$$
où $\delta P$ est la contribution positive ou négative de la pompe magnétohydrodynamique 5.

Si le volume d'interaction électromagnétique peut être réduit, à l'endroit où la pompe agit sur le conduit 9, à un parallépipède de largeur $\underline{e}$, il sera alors aisé de délivrer par la pompe un courant de l'ordre de 10 ampères et d'atteindre un champ magnétique tranverse de l'ordre de 0,2 Tesla avec des ferrites au samarium - cobalt, ceci avec une épaisseur $\underline{e}$ de l'ordre de 0,5 mm. On pourra alors obtenir une contribution de pression de la pompe de $\delta P = + 4\,000$ Pas-

cal. Cette pression correspond à environ une hauteur de 5 cm d'étain fondu.

Si l'on s'intéresse maintenant au problème des tensions superficielles, on notera tout d'abord qu'il est conseillé de fabriquer les parties de l'appareil qui sont en contact avec le métal en fusion dans des matériaux non mouillés par ce même métal, les forces de tension superficielles opposant alors une pression à la pénétration du métal fondu dans le conduit 9.

Pour que la pompe ne se désamorce pas sous l'effet des forces de tension, il conviendra tout d'abord que la pression du métal fondu à l'entrée de la pompe (pression légèrement supérieure à $P_0$) reste supérieure à la pression développée par ces forces de tension superficielle.

D'autre part, il sera également préférable qu'au moment de la coupure électrique volontaire ou accidentelle de l'appareil (donc en l'absence de pression induite par la pompe), le réservoir 1 ne se vide pas spontanément à travers le conduit et sa buse.

Pour cela, il conviendra que la pression au niveau de la buse 12 reste inférieure à la pression $P_b$ induite par les tensions superficielles dans le canal étranglé de sortie du conduit, soit :

$$P_0 + H_0 < P_b$$

Dans ces conditions, pour que la pompe induise un écoulement, il suffira alors que la pression induite électromagnétiquement par la pompe s'ajoute à la pression hydrostatique et soit telle que :

$$P_0 = H_O + \delta P > Pb$$

Pour arrêter la coulée de métal, on pourra alors soit couper le courant d'alimentation de la pompe 5, soit pour éviter la formation d'une goutte supplémentaire, inverser momentanément le sens de circulation de ce courant.

Dans un exemple de réalisation la tension superficielle d'un bain de soudure pourra être telle que $T \approx 0,52$ N/m (T étant la force par unité de longueur liée à l'énergie de surface du métal liquide), ce qui, pour un canal de pompe pourvu d'un étranglement de sortie circulaire d'environ 0,2 mm de diamètre, équivaudra à une pression $P_b$ de l'ordre de 15 cm de métal fondu.

Reportons-nous maintenant aux figures 5 et 6 relatives aux moyens qui peuvent être prévus à l'endroit de la buse de sortie 12 pour permettre de former par écrasement une piste d'alliage plus large ou d'apporter conjointement un flux de brasure.

Le métal fondu s'écoulant à travers le conduit se dépose sur le substrat et se répartit en fonction de la mouillabilité de ce substrat et des forces de tension superficielles.

Cette répartition peut en fait être modifée par déformation du métal fondu, ceci par une action mécanique de pièces liées à la buse 12 et venant s'approcher de la surface du substrat.

Bien entendu, on pourrait pour cela conformer spécifiquement la lèvre de la buse elle-même. Mais on a préféré en espèce prévoir une pièce indépendante repérée 41 sur la figure 4 où l'on a représenté le métal fondu 3 s'écoulant de la buse 12 pour former sur le substrat 7 un cordon de liquide 3a. Dans l'exemple représenté, le cordon 3a a été écrasé pour former un ruban plus mince 3b, ceci sous l'action du patin 41 fixé sous le corps du réservoir 1, juste derrière l'orifice de sortie de la buse 12 si l'on considère que le réservoir se déplace dans le sens de la flèche 43.

Le patin 41 qui, pour former le ruban 3b, se déplace à une distance contrôlée de la surface du substrat, peut se présenter comme une pièce réalisée en un isolant électrique (céramique...) ou métal lequel, si nécessaire, peut être chauffé indépendamment par une résistance chauffante schématisée en 45 qui peut être régulée par une sonde de température 47.

Dans un certain nombre d'applications, il pourra s'avérer utile de prévoir la possibilité de diffuser un flux décapant à l'endroit des zones à métalliser du substrat, et ceci préalablement à la coulée de métallisation.

En particulier dans le cas où l'appareil sera incorporé à un système de déplacement relatif réservoir à dispositif de coulée/substrat, on pourra associer à l'appareil un dispositif dispenseur de flux, du type vaporisateur, précédant la buse de l'appareil dans le mouvement de parcours des pistes à métalliser.

Sur la figure 5 est présentée une disposition assurant à la fois la distribution de flux sous forme gazeuse (par exemple gaz neutre avec adjonction d'hydrogène ou acide formique,...) et la protection contre l'oxydation du métal fondu en sortie de la buse 12. Un gaz neutre ou réducteur est injecté par un tube 49 débouchant au voisinage de la buse, le gaz provenant par exemple de la source 50 et distribué par ce conduit étant confiné à cet endroit par une jupe périphérique 51 s'étendant périphériquement autour du conduit et affleurant sans le toucher le substrat 7.

Intéressons-nous maintenant à la figure 6 pour décrire brièvement un dispositif pouvant être envisagé pour une commande automatisée du système de métallisation qui vient d'être présenté.

L'exemple de la figure 6 est en particulier adapté à l'étamage de pistes sur une feuille plane formant le substrat 7, lequel repose ici sur le plateau 53 d'une table X-Y.

En 1 on aperçoit le réservoir à métal fondu sous lequel, en 12, apparaît la buse de coulée. Le réservoir est solidaire du châssis ou bras mobile 55 de la table, les mouvements en X et en Y relatifs de la table et du système de dépôt sont assurés par les moteurs 57 et 59. Ces moteurs peuvent être servocommandés par l'intermédiaire d'unités d'alimentation 61, 63, elles-mêmes pilotés par un automate 65. Cet automate commande le déplacement relatif réservoir/substrat de manière à positionner la coulée à l'endroit des emplacements où le long des pistes à métalliser du substrat. Les coordonnées des trajets à suivre pourront être stockées dans une unité mémoire 67 adjointe à l'automate, lequel commande aussi la source de courant continu programmable 69 d'alimentation de la pompe magnétohydrodynamique 5.

Il peut en outre être recommandé de coupler le système de coulée à un asservissement de hauteur piloté par un capteur si la planéité du substrat 7 et/ou la précision de la table X-Y ne permettent pas de conserver la distance buse/substrat sensiblement constante.

Par ailleurs, l'automate 65 peut être relié par l'intermédiaire d'un câble souple 73 au système de coulée pour prévenir l'opérateur qu'une recharge en alliage est nécessaire, ceci en association avec les capteurs de niveau 41 et 43 de la figure 1.

Bien entendu, on a décrit là un exemple de réalisation adapté à la métallisation d'une surface sensiblement plane. Le principe de l'invention pourrait toutefois être parfaitement appliqué à la métallisation d'un cylindre, d'un bloc multiface, voire d'un ruban souple.

## Revendications

1. - Procédé pour apporter localement un composé métallique (3) fondu à un substrat (7) avec lequel ledit composé est compatible chimiquement, dans lequel procédé :

   a) on maintient dans un réservoir (1) le composé métallique (3) dans un état fondu,

   b) on place le réservoir (1) au-dessus du substrat (7),

   c) on coule localement le composé fondu sur ce substrat pour y créer en surface une couche d'apport (3, 3a),

   d) et on laisse refroidir cette couche pour qu'elle se soude au substrat,

   caractérisé en ce que, lors de l'étape c), on coule par gravité le composé métallique fondu directement sur le substrat et on dose la quantité de composé à couler en imposant, lors de la coulée, l'action combinée d'un courant électrique que l'on fait circuler à travers le composé s'écoulant et d'un champ magnétique statique.

2. - Procédé selon la revendication 1 caractérisé en ce que, au moment où une coulée doit être effectuée, on élève la température du composé métallique (3) contenu dans le réservoir au-delà de sa température de fusion et on coule ce composé (3) sur le substrat à cette température plus élevée.

3. - Procédé selon l'une quelconque des revendications précédentes caractérisé en ce qu'en fin de l'étape c), on interrompt la coulée en inversant le sens de circulation dudit courant électrique imposé.

4. - Appareil pour apporter localement un composé métallique (3) fondu à un substrat (7) avec lequel ledit composé est compatible chimiquement, en vue d'assurer leur soudage relatif, cet appareil comprenant :

   - un réservoir (1) pour contenir ledit composé dans son état fondu,

   - des moyens (25) de chauffage du composé métallique contenu dans le réservoir pour que la température de ce composé y atteigne au moins la température de fusion,

   - un conduit (9, 12) auquel se raccorde ledit réservoir (1) en partie inférieure et à travers lequel le composé peut couler vers le substrat (7),

   - et des moyens de dosage (5) pour doser la quantité de composé métallique (3) s'écoulant dans le conduit (9, 12),

   caractérisé en ce que ces moyens de dosage (5) de la coulée comprennent une pompe magnétohydrodynamique disposée localement autour dudit conduit (9).

5. - Appareil selon la revendication 4 caractérisé en ce que la pompe magnétohydrodynamique (5) comprend:

   - un corps de pompe (6) renfermant :

   - deux aimants (15a, 15b) permanents disposés l'un en face de l'autre sensiblement au même niveau autour du conduit (9), leurs pôles opposés se faisant face,

   - deux électrodes (17a, 17b) reliées à une source de courant continu (69), ces électrodes se faisant face et étant disposées autour du conduit (9) sensiblement au niveau des aimants en étant orientées sensiblement perpendiculairement à ces derniers,

   - deux couches (23a, 23b) d'isolant électrique ou de diélectrique s'étendant le long des deux pôles opposés se faisant face des aimants (15a, 15b) pour définir avec deux extrémités dénudées se faisant face des électrodes (17a, 17b) la limite extérieure du conduit (9) à l'endroit de la pompe,

   - des manchons (21a, 21b) d'isolement électrique des électrodes par rapport au corps (6) de la pompe.

6. - Appareil selon la revendication 4 ou la revendication 5 caractérisé en ce qu'il comprend également :

   - un tube (33) d'injection de gaz plongeant dans ledit composé métallique (3) fondu jusque vers le fond du réservoir (1) qui définit un espace fermé, et

   - des moyens (50) d'alimentation reliés audit tube (33) pour l'alimenter en gaz.

7. - Appareil selon la revendication 6 caractérisé en ce que lesdits moyens (50) d'alimentation approvisionnent le tube (33) d'injection en gaz neutre ou réducteur pour maintenir en surface du composé contenu dans le réservoir une atmosphère confinée non oxydante.

8. - Appareil selon la revendication 6 ou la revendication 7 caractérisé en ce que le conduit (9) d'écoulement du composé métallique comprend au moins un étranglement (12) conformé de manière que la pression ($P_b$) induite par les forces de tension superficielle à l'endroit de cet étranglement soit supérieure à la somme de la surpression ($P_0$) de gaz (par rapport à la pression atmosphérique) injectée par ledit tube (33) et de la pression hydrostatique ($H_0$) liée à la hauteur de composé métallique contenu dans le réservoir entre le niveau (34) où le tube (33) d'injection débouche dans ledit réservoir et l'extrémité d'ouverture de l'étranglement (12).

**9.** - Appareil selon l'une quelconque des revendications 4 à 8 caractérisé en ce que le conduit (9) d'écoulement du composé métallique comprend, à proximité de sa sortie (12), un patin (41) d'écrasement devant se situer à une distance du substrat inférieure à l'épaisseur du composé métallique délivré, pour étaler ce dernier sur le substrat .

**10.** - Appareil selon l'une quelconque des revendications 4 à 9 caractérisé en ce qu'il comprend en outre un dispositif (49) distributeur de flux préparatoire pour la soudure comportant :

. une jupe (51) propre à affleurer le substrat (7) et entourant ladite sortie (12) du conduit (9) en réservant autour de celle-ci un espace confiné (52),

. un tube (49) d'amenée d'un gaz neutre ou réducteur pour le composé métallique, ce tube débouchant à l'intérieur dudit espace confiné, et

. une source (50) d'alimentation du tube (49) en gaz neutre ou réducteur.

FIG.1

33  13  37  35  41  43

1  39

27

25

31  3

29

2

11  5

9  12  II

7

10

19a

21a

23a  17a

9

15a  15b

23b

6

5  17b

21b  19b

FIG.2

FIG.3

FIG.4

EP 0 491 599 A1

FIG.5

FIG.6

10

**Office européen des brevets**

# RAPPORT DE RECHERCHE EUROPEENNE

Numero de la demande

EP 91 40 3328
Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | RESEARCH DISCLOSURE<br>no. 290, Juin 1988, NEW YORK (US)<br>PUBLICATION ANONYME: 'Molten Solder Applicator Devices' | 1,3 | B23K3/06<br>H05K3/34 |
| A | * le document en entier * | 4 | |
| Y | SU-A-481 325 (AS UKR CYBERN) | 1,3 | |
| A | * le document en entier * | 4,5 | |
| A | GB-A-1 418 827 (GLAVERBEL-MECANIVER)<br>* page 5, ligne 42 - ligne 54 *<br>* page 5, ligne 102 - page 6, ligne 2 *<br>* page 7, ligne 35 - ligne 48; figures 1,4,9 * | 1,4 | |
| A | PATENT ABSTRACTS OF JAPAN<br>vol. 7, no. 227 (M-248)(1372) 7 Octobre 1983<br>& JP-A-58 119 461 ( HIGASHIYAMA DENKI KOGYO K.K. ) 15 Juillet 1983<br>* abrégé * | 1,4 | |
| A | PATENT ABSTRACTS OF JAPAN<br>vol. 9, no. 238 (M-416)(1961) 25 Septembre 1985<br>& JP-A-60 092 072 ( TOSHIBA K.K. ) 23 Mai 1985<br>* abrégé * | 1,4 | **DOMAINES TECHNIQUES RECHERCHES (Int. Cl.5)**<br><br>B23K<br>H05K<br>B05B |
| A | PATENT ABSTRACTS OF JAPAN<br>vol. 9, no. 29 (M-356)(1752) 7 Février 1985<br>& JP-A-59 174 273 ( TOSHIBA K.K. ) 2 Octobre 1984<br>* abrégé * | 1,4 | |
| A | PATENT ABSTRACTS OF JAPAN<br>vol. 7, no. 41 (M-194)(1186) 18 Février 1983<br>& JP-A-57 190 769 ( TOKYO SHIBAURA DENKI K.K. ) 24 Novembre 1982<br>* abrégé * | 1,4,7 | |
|  | -/-- | | |

Le présent rapport a été établi pour toutes les revendications

| Lieu de la recherche | Date d'achèvement de la recherche | Examinateur |
|---|---|---|
| LA HAYE | 25 MARS 1992 | ARAN D.D. |

Office européen
des brevets

**RAPPORT DE RECHERCHE EUROPEENNE**

Numero de la demande

EP    91 40 3328
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IBM TECHNICAL DISCLOSURE BULLETIN. vol. 15, no. 5, Octobre 1972, NEW YORK US page 1497; F.H. SARNACKI ET AL.: 'SOLDER SPREADER APPARATUS AND METHOD' * le document en entier * | 1,4,9 | |
| A | PATENT ABSTRACTS OF JAPAN vol. 7, no. 169 (M-231)(1314) 26 Juillet 1983 & JP-A-58 074 276 ( TOKYO SHIBAURA DENKI K.K. ) 4 Mai 1983 * abrégé * | 1,4 | |

DOMAINES TECHNIQUES RECHERCHES (Int. Cl.5)

Le présent rapport a été établi pour toutes les revendications

| Lieu de la recherche | Date d'achèvement de la recherche | Examinateur |
|---|---|---|
| LA HAYE | 25 MARS 1992 | ARAN D.D. |

EPO FORM 1503 03.82 (P0402)